# EUROPEAN PATENT APPLICATION

(11) **EP 4 614 786 A1**
(43) Date of publication of application: **10.09.2025**
(21) Application number: 24161126.8
(22) Date of filing: 04.03.2024
(51) Int. Cl.: H02M 1/32, H02M 3/156, H02M 3/158, H02M 1/36

(54) **OUTPUT VOLTAGE SENSE PROTECTION DEVICE AND METHOD**

(71) Applicant: Infineon Technologies Austria AG, 9500 Villach (AT)
(72) Inventor: YOU, Zhiqing, Torrance, 90505 (US); NG, Tim, Monterey Park, 91755 (US)
(74) Representative: Infineon Patent Department

(57) **Abstract**

A control circuit and a corresponding method is presented. The control circuit may be configured to control a power converter. The control circuit may be configured to receive a voltage signal indicative of an output voltage at an output of the power converter. The control circuit may be configured to receive a current signal indicative of an output current at the output of the power converter. The control circuit may be configured to determine a fault condition associated with the voltage signal based on the current signal and based on the voltage signal. By determining a fault condition based on an analysis of the sensed output voltage and the sensed output current, it becomes possible to detect the fault condition in a simple and efficient manner.

## Description

### Technical field

The present document relates to output voltage sense protection devices and methods. In particular, the present document relates to techniques to detect faulty measurements of an output voltage of a power converter, and to techniques to protect a load at the output of the power converter from excessively high voltages.

### Background

Due to assembly issues, output voltage sense lines which report an output voltage at an output of a power converter may be affected by open circuits or short circuits. A controller which is in charge of controlling the power converter may mistakenly assume that the output voltage is still at a low voltage level. This may be in particular problematic during startup of the power converter: The controller may continue to increase (a) the pulse width and/or (b) the frequency of the pulses transmitted to the power converter for increasing power flow in the power converter. This may result in excessively high output voltages which may damage the expensive output loads such as CPU, ASIC, FPGA devices, etc..

Thus, it is an object of the present invention to provide an efficient device and method to detect an incorrectly sensed value of an output voltage of a power converter.

### Summary

According to an aspect, a control circuit is presented. The control circuit may be configured to control a power converter. The control circuit may be configured to receive a voltage signal indicative of an output voltage at an output of the power converter. The control circuit may be configured to receive a current signal indicative of an output current at the output of the power converter. The control circuit may be configured to determine a fault condition associated with the voltage signal based on the current signal and based on the voltage signal.

The power converter may be e.g. a switched mode power supply (SMPS). As will be discussed below in more detail, the power converter may be a multi-phase power converter, wherein each phase may comprise a power stage coupled in series with an inductor. The individual phases may be coupled in parallel, and the output currents of the inductor may be summed up at the output of the power converter to form the power converter's output current. As will be discussed below, the current signal may comprise a plurality of phase current signals for the individual phases of the power converter.

The control circuit may comprise one or more processors for implementing or at least initiating the functional features of the control circuit described within this document. Specifically, the control circuit may comprise a microcontroller MCU for carrying out the described functions.

The features of the control circuit described within this document, and in particular the functional features of the control circuit, may be implemented by respective software or hardware units, or by a combination of both. Hardware units may be implemented using digital or analog circuit elements, or by a combination of both.

By determining a fault condition (only) based on an analysis of the sensed output voltage and the sensed output current, it becomes possible to detect the fault condition in a simple and efficient manner. In particular, fault detection may be implemented purely on the control circuit by updating the control circuit firmware, and no additional hardware elements such as current sources, comparators, or other analog circuitry is required.

The control circuit may be configured to determine the fault condition if a value of the current signal exceeds a current fault threshold and if a value of the voltage signal is below a voltage fault threshold. To be more specific, the control circuit may be configured to determine the fault condition if, at a point in time, a value of the current signal exceeds the current fault threshold and if, roughly at the same point in time, a value of the voltage signal is below the voltage fault threshold.

In this way, it becomes possible to detect the fault condition that the output signal may not correctly represent the real output voltage at the output of the power converter. Typically, e.g. during a startup of the power converter, the real output voltage increases when the output current increases. If, however, the voltage sensing is not working correctly (e.g. due to a short circuit or open circuit), the sensed output voltage will falsely indicate a low output voltage, although in reality, a real high output voltage may damage the load at the output of the power converter. By detecting an increased output current and a non-increased output voltage, this fault condition may be detected in an efficient manner.

The control circuit may comprise a current comparator configured to compare the value of the current signal with the current fault threshold and a voltage comparator configured to compare the value of the voltage signal with the voltage fault threshold. Both the current comparator and the voltage comparator may be implemented by software running on a microcontroller of the control unit. Alternatively, the comparators may be implemented using hardware circuits.

The control circuit may be configured to synchronize operation of the current comparator and the voltage comparator such that both comparisons are performed roughly at the same point in time. This point in time may be e.g. during the start-up time of the power converter for an early detection of a faulty voltage signal. The control circuit may further comprise a logic AND-gate, wherein an output of the current comparator is coupled to a first input of the logic AND-gate, and wherein an output of the voltage comparator is coupled to a second input of the logic AND-gate. The output of the logic AND-gate may indicate the fault condition. Again, the logic AND-gate may be implemented by software or hardware.

The control circuit may be configured to determine the maximum value of the current signal within a predetermined time interval. The control circuit may be configured to use this maximum value as the value of the current signal for determining the fault condition. For example, the control circuit may comprise a hardware or software timer for implementing the predetermined time interval.

The control circuit may be configured to determine the maximum value of the voltage signal within said predetermined time interval. The control circuit may be configured to use this maximum value as the value of the voltage signal for determining the fault condition. Hence, the control circuit may be configured to determine the fault condition if the maximum value of the current signal exceeds the current fault threshold and if the maximum value of the voltage signal is below the voltage fault threshold.

The control circuit may be configured to start the predetermined time interval when a first pulse width modulation PWM pulse is transmitted from the control circuit to a power stage of the power converter. Thus, the predetermined time interval may start right at the beginning of the start-up of the power converter. In response to reception of the first PWM pulse, a switching element of the power stage (e.g. a high side switching element) may be turned on to initiate current and power flow withing the power converter.

The control circuit may be configured to compare the maximum value of the current signal with the current fault threshold right after the predetermined time interval has lapsed. Analogously, the control circuit may be configured to compare the maximum value of the voltage signal with the voltage fault threshold right after the predetermined time interval has lapsed.

The control circuit may be configured to receive the voltage signal via an external output voltage sense line. The fault condition associated with the voltage signal may be associated with an open circuit condition or a short circuit condition associated with the external output voltage sense line. As a result of the fault condition, the volage signal may indicate an output voltage which is lower than the actual/real output voltage at the output of the power converter. In particular, due to an open circuit or a short circuit, the voltage signal may indicate an output voltage of approximately 0V, whereas the actual output voltage is substantially higher than 0V.

The control circuit may be configured to, in response to determining the fault condition, shut down the power converter. For instance, the control circuit may be configured to, in response to determining the fault condition, send a control signal to the power converter for turning off one or more switching elements of the power converter. The control circuit may be configured to transmit a PWM signal to the power converter for driving switches of the power converter, and to, in response to determining the fault condition, stop increasing a duty cycle of the PWM signal.

The power converter may be a multi-phase power converter. The control circuit may be configured to receive a plurality of phase current signals indicative of the currents of the different phases of the multi-phase power converter. The control circuit may be configured to determine the current signal based on the phase current signals. For example, the control circuit may be configured to determine the current signal based on a linear combination of the phase current signals. In particular, the control circuit may be configured to determine the current signal by summing the phase current signals.

According to yet another aspect, a method of controlling a power converter is presented. The method may comprise steps corresponding to the functional features of the control circuit described throughout this document. Specifically, the method may comprise receiving, by a control circuit, a voltage signal indicative of an output voltage at an output of the power converter. The method may comprise receiving, by the control circuit, a current signal indicative of an output current at the output of the power converter. The method may comprise determining, by the control circuit, a fault condition associated with the voltage signal based on the current signal and based on the voltage signal.

The step of determining may comprise determining the fault condition if a value of the current signal exceeds a current fault threshold and if a value of the voltage signal is below a voltage fault threshold.

The method may comprise determining the maximum value of the current signal within a predetermined time interval, and using this maximum value as the value of the current signal for determining the fault condition.

The method may comprise comparing, by a current comparator, the (maximum) value of the current signal with the current fault threshold. The method may comprise comparing, by a voltage comparator, the value of the voltage signal with the voltage fault threshold.

The method may comprise determining, by the control circuit, the maximum value of the voltage signal within said predetermined time interval. The method may comprise using, by the control circuit, this maximum value as the value of the voltage signal for determining the fault condition. The method may comprise determining, by the control circuit, the fault condition if the maximum value of the current signal exceeds the current fault threshold and if the maximum value of the voltage signal is below the voltage fault threshold.

The method may comprise starting, by the control circuit, the predetermined time interval when a first pulse width modulation PWM pulse is transmitted from the control circuit to a power stage of the power converter.

The method may comprise receiving, by the control circuit, the voltage signal via an external output voltage sense line. The fault condition associated with the voltage signal may be associated with an open circuit condition or a short circuit condition associated with the external output voltage sense line. The method may comprise shutting, by the control circuit, in response to determining the fault condition, the power converter down. The method may comprise transmitting, by the control circuit, a PWM signal to the power converter for driving switches of the power converter. The method may comprise stopping, by the control circuit, in response to determining the fault condition, to increase a duty cycle of the PWM signal.

According to a third aspect, a computer program is presented. The computer program may comprise instructions which, when executed by one or more processors of a control circuit, cause the control circuit to perform the operations described within this document.

The computer program may be e.g. software/firmware which is loaded into the memory of the control circuit. To this end, the computer program may be transmitted over a network and the control circuit may comprise a network interface device for receiving the computer program. Alternatively, the computer program may be distributed on a data carrier and may be downloaded to the control circuit. In general, the computer program may be stored on a non-transitory computer-readable medium. This document discloses a non-transitory computer-readable medium storing instructions that, when executed by one or more processors of a control circuit, cause the control circuit to perform the steps described throughout the document.

It should be noted that the methods and systems including its preferred embodiments as outlined in the present document may be used stand-alone or in combination with the other methods and systems disclosed in this document. In addition, the features outlined in the context of a system are also applicable to a corresponding method. Furthermore, all aspects of the methods and systems outlined in the present document may be arbitrarily combined. In particular, the features of the claims may be combined with one another in an arbitrary manner.

In the present document, the term "couple" or "coupled" refers to elements being in electrical communication with each other, whether directly connected e.g., via wires, or indirectly connected via other circuit elements between them. For example, two elements may be said to be coupled even if there is a circuit element such as a switch (which may be turned on and off) in between them. On the other hand, the term "connect" or "connected" refers to elements being directly electrically connected with each other, e.g. via wires, and no circuit elements are located between them.

### Short description of the figures

The present invention is illustrated by way of example, and not by way of limitation, in the figures in which like reference numerals refer to similar or identical elements, and in which
Fig. 1 shows an exemplary power converter with a control circuit,
Fig. 2 shows exemplary signal waveforms of a power converter without the claimed over voltage sense protection,
Fig. 3 shows an exemplary functional diagram of a control circuit according to the presented invention, and
Fig. 4 shows experimental results for control with and without OSP.

### Detailed Description

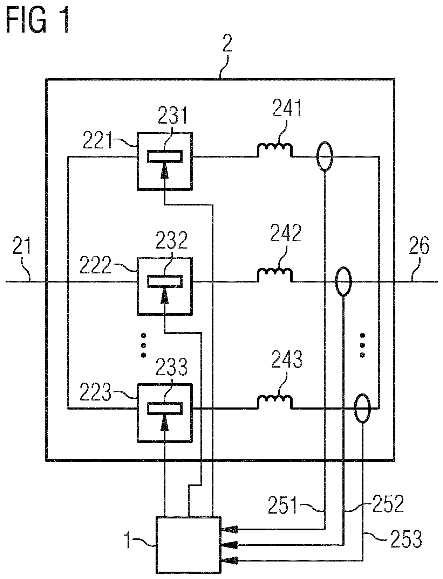

Fig. 1 shows an exemplary power converter 2 with a control circuit 1. The power converter has an input 21 and an output 26. In the illustrated example, the power converter 2 is a multi-phase power converter. As the power converter is of the buck type, the output voltage is typically lower than the input voltage, and the output current is higher than the input current. This holds in particular since the different phase currents are added up at the output 26 of the power converter. The multi-phase power converter 2 comprises a plurality of parallel power stages 221, 222, 223 with respective switching elements 231, 232, 233 which are controlled by respective control signals (e.g. PWM signals) transmitted by the control circuit 1. Each phase of the power converter comprises a respective inductor 241, 242, 243 in series with the respective power stage. The inductor currents a sensed and reported via sense lines 251, 252, 253 to the control circuit 1. Depending on the distance between the point of the sensing and the control circuit 1, sense lines may be distinguished into local or remote sense lines. The output voltage is also sensed and reported to the control circuit 1 (not shown). The output voltage by be reported via output voltage sense lines.

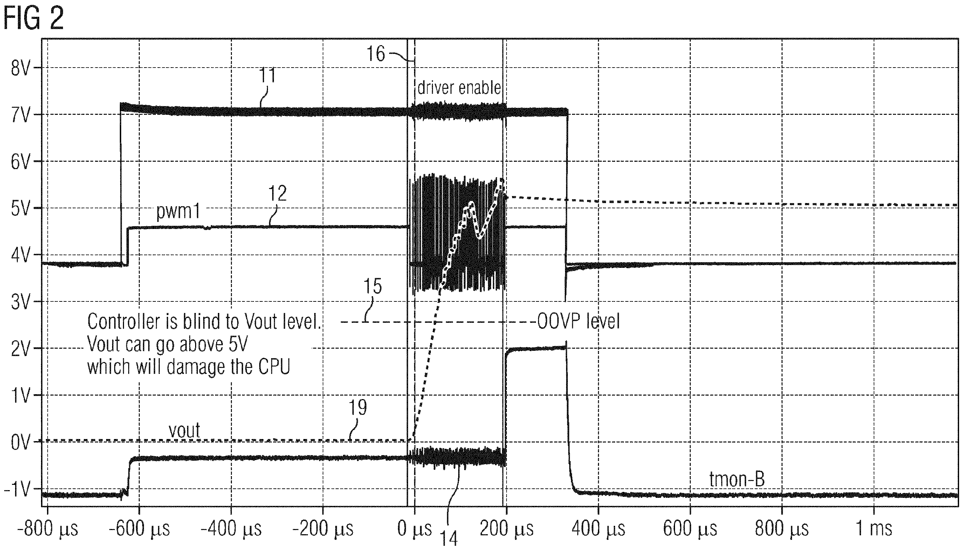

Fig. 2 shows exemplary signal waveforms of a power converter without the claimed over voltage sense protection (OSP). Fig. 2 shows a driver enable signal 11, a PWM signal 12 for controlling switching of one or more power stages, the actual output voltage Vout 13 at the output 26 of the power converter, and a signal 14 indicative of a sensed temperature. In the depicted example, switching of the power stage is initiated at time 16, and the output voltage starts increasing. As the output voltage sensing incorrectly reports a low output voltage (e.g. due to an open circuit or a short circuit related to the sense line), the control circuit 1 continues to increase the output voltage despite the output voltage exceeding the Output Overvoltage Protection level OOVP 15. This behavior results in a dangerously high output volage which may damage the load.

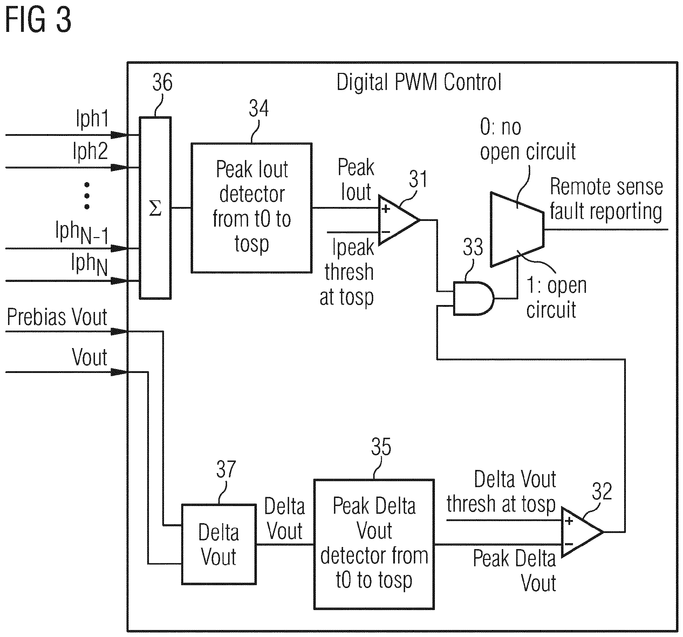

Fig. 3 shows an exemplary functional diagram of a control circuit according to the presented invention. In particular, Fig. 3 shows an exemplary embodiment of the OSP mechanism within a control circuit. The control circuit determines the fault condition (here: an open circuit) if a value of the current signal (Peak Iout) exceeds a current fault threshold (Ipeak thresh at tosp) and if a value of the voltage signal (Peak Delta Vout) is below a voltage fault threshold (Delta Vout thresh at tosp). The current comparison may be performed by comparator 31, and the voltage comparison may be performed by comparator 32. Both comparisons may be performed at the same time tosp, and the output may be provided to AND-unit 33.

For example, the comparisons may be based on the current values and voltage values at time tosp. Alternatively, optional peak detectors 34 and 35 may be used for determining peak/maximum values during a predetermined time interval of duration (tosp - t0), assuming that the predetermined time interval starts at time t0 (e.g. when the first switching pulse is transmitted to the power converter) and ends at time tosp. Peak detector 34 determines the maximum current value during this predetermined time interval, and peak detector 35 determines the maximum voltage value during this predetermined time interval. However, since both voltage and current values are mainly constantly increasing, the maximum values may be most likely found at the end of the predetermined time interval.

As another optional feature, the control circuit may use summing unit 36 for summing the values indicative of the individual phase currents of the power converter. Moreover, to account for offset voltages at the output of the power converter, the optional Delta Vout determination unit 37 may be used. The offset voltages may be generated by various leakage currents at the output of the power converter. Said leakages may be induced to the load and they may be caused by components of the voltage regulator as well as from other rails in the system. The offset voltage may result from such leakages when the voltage regulator is not regulating. As a controller, it is desirable to preposition the target output to ramp starting from the offset voltage instead of 0V to prevent stress on the leakage paths.

By using a suitable Prebias Vout voltage, these offset voltages may be counteracted. The Vout determination unit 37 may determine a difference between the measured/sensed output voltage Vout and said Prebias voltage (e.g. Vout- Prebias Vout).

As shown in Fig. 3, the open circuit condition associated with the sensed voltage may be reported (Remote sense fault reporting) and the control circuit may react accordingly. For instance, in order to avoid an overvoltage at the output of the power converter, the power converter may be turned off completely.

The presented output voltage sense protection OSP may have the following advantages: It may reliably protect the output load and may report the remote sense fault which will give the clear direction to the user where the problem is coming from. Moreover, no additional analog change is required, hence no controller re-spin. This feature may be implemented by a firmware patch and customers only need to update the firmware for their control circuits in the field to get this feature. Thus, the invention may increase reliability and robustness of power converter control, in particular in the field of multiphase controller products.

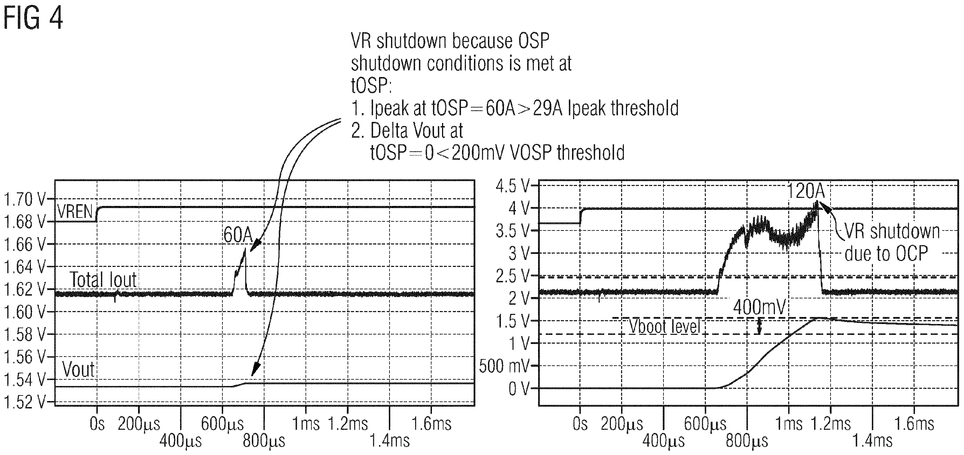

Fig. 4 shows experimental results for control with and without OSP. In the left diagram of Fig. 4, OSP according to the present invention is enabled and a short condition with a short across the remote volage sense lines occurs. The duration of the predetermined time interval is tosp=50us. The current fault threshold (Ipeak threshold at tOSP) is 29A, and the voltage fault threshold (Delta Vout threshold at tOSP) is set to 200mV. As a result, the voltage regulator VR (also denoted as power converter) is shutdown since the (maximum) output current has reached 60A at the end of the predetermined time interval.

In the right diagram of Fig. 4, OSP according to the present invention is disabled. The control circuit is blind and mistakenly thinks that the output voltage Vout is not ramping up. In this scenario, the output current is rising up to 120A and is only stopped by the conventional overcurrent protection OCP mechanism which shuts down the voltage regulator. At the time of shutdown, however, the output voltage is already 400mV above the regular boot level of 1.2V.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A control circuit configured to control a power converter, wherein the control circuit is configured to receive a voltage signal indicative of an output voltage at an output of the power converter, to receive a current signal indicative of an output current at the output of the power converter, and to determine a fault condition associated with the voltage signal based on the current signal and based on the voltage signal.

2. The control circuit according to claim 1, wherein the control circuit is configured to determine the fault condition if a value of the current signal exceeds a current fault threshold and if a value of the voltage signal is below a voltage fault threshold.

3. The control circuit according to claim 2, wherein the control circuit comprises a current comparator configured to compare the value of the current signal with the current fault threshold and a voltage comparator configured to compare the value of the voltage signal with the voltage fault threshold.

4. The control circuit according to any one of the preceding claims, wherein the control circuit is configured to determine the maximum value of the current signal within a predetermined time interval, and wherein the control circuit is configured to use this maximum value as the value of the current signal for determining the fault condition.

5. The control circuit according to claim 4, wherein the control circuit is configured to determine the maximum value of the voltage signal within said predetermined time interval, and wherein the control circuit is configured to use this maximum value as the value of the voltage signal for determining the fault condition.

6. The control circuit according to claim 5, wherein the control circuit is configured to determine the fault condition if the maximum value of the current signal exceeds the current fault threshold and if the maximum value of the voltage signal is below the voltage fault threshold.

7. The control circuit according to any one of claims 4 to 6, wherein the control circuit is configured to start the predetermined time interval when a first pulse width modulation PWM pulse is transmitted from the control circuit to a power stage of the power converter.

8. The control circuit according to any one of the preceding claims, wherein the control circuit is configured to receive the voltage signal via an external output voltage sense line, and wherein the fault condition associated with the voltage signal is associated with an open circuit condition or a short circuit condition associated with the external output voltage sense line.

9. The control circuit according to any one of the preceding claims, wherein the control circuit is configured to, in response to determining the fault condition, shut down the power converter.

10. The control circuit according to any one of the preceding claims, wherein the control circuit is configured to transmit a PWM signal to the power converter for driving switches of the power converter, and to, in response to determining the fault condition, stop increasing a duty cycle of the PWM signal.

11. The control circuit according to any one of the preceding claims, wherein the power converter is a multi-phase power converter, wherein the control circuit is configured to receive a plurality of phase current signals indicative of the currents of the different phases of the multi-phase power converter, and wherein the control circuit is configured to determine the current signal based on the phase current signals.

12. A method of controlling a power converter, the method comprising
- receiving, by a control circuit, a voltage signal indicative of an output voltage at an output of the power converter,
- receiving, by the control circuit, a current signal indicative of an output current at the output of the power converter, and
- determining, by the control circuit, a fault condition associated with the voltage signal based on the current signal and based on the voltage signal.

13. The method according to claim 12, wherein the determining comprises determining the fault condition if a value of the current signal exceeds a current fault threshold and if a value of the voltage signal is below a voltage fault threshold.

14. The method according to claim 12 or 13, comprising determining the maximum value of the current signal within a predetermined time interval, and using this maximum value as the value of the current signal for determining the fault condition.

15. A computer program comprising instructions which, when executed by one or more processors of a control circuit, cause the control circuit to perform operations of any one of claims 12 to 14.

## Amended claims

### Amended claims in accordance with Rule 137(2) EPC.

1. A control circuit (1) configured to control a power converter (2), wherein the control circuit (1) is configured to receive a voltage signal indicative of an output voltage (V_{OUT}) at an output (26) of the power converter (2), to receive a current signal indicative of an output current (I_{OUT}) at the output (26) of the power converter (2), and to determine a fault condition associated with the voltage signal based on the current signal and based on the voltage signal, and **characterized in that** the control circuit (1) is configured to determine the fault condition if a value of the current signal exceeds a current fault threshold (Ipeak thresh) and if a value of the peak Delta output voltage (Peak Delta Vout) is below a voltage fault threshold (Delta Vout thresh).

2. The control circuit (1) according to claim 1, wherein the control circuit (1) comprises a current comparator configured to compare the value of the current signal with the current fault threshold and a voltage comparator configured to compare the value of the voltage signal with the voltage fault threshold.

3. The control circuit (1) according to any one of the preceding claims, wherein the control circuit (1) is configured to determine the maximum value of the current signal within a predetermined time interval (tosp), and wherein the control circuit (1) is configured to use this maximum value as the value of the current signal for determining the fault condition.

4. The control circuit (1) according to claim 3, wherein the control circuit (1) is configured to determine the maximum value of the voltage signal within said predetermined time interval (tsop), and wherein the control circuit (1) is configured to use this maximum value as the value of the voltage signal for determining the fault condition.

5. The control circuit (1) according to claim 4, wherein the control circuit (1) is configured to determine the fault condition if the maximum value of the current signal exceeds the current fault threshold and if the maximum value of the voltage signal is below the voltage fault threshold.

6. The control circuit (1) according to any one of claims 3 to 5, wherein the control circuit (1) is configured to start the predetermined time interval when a first pulse width modulation PWM pulse is transmitted from the control circuit (1) to a power stage (221, 222, 223) of the power converter (2).

7. The control circuit (1) according to any one of the preceding claims, wherein the control circuit (1) is configured to receive the voltage signal via an external output voltage sense line (251, 252, 253), and wherein the fault condition associated with the voltage signal is associated with an open circuit condition or a short circuit condition associated with the external output voltage sense line (251, 252, 253).

8. The control circuit (1) according to any one of the preceding claims, wherein the control circuit (1) is configured to, in response to determining the fault condition, shut down the power converter (2).

9. The control circuit (1) according to any one of the preceding claims, wherein the control circuit (1) is configured to transmit a PWM signal to the power converter (2) for driving switches (231, 232, 233) of the power converter (2), and to, in response to determining the fault condition, stop increasing a duty cycle of the PWM signal.

10. The control circuit (1) according to any one of the preceding claims, wherein the power converter (2) is a multi-phase power converter, wherein the control circuit (1) is configured to receive a plurality of phase current signals indicative of the currents of the different phases of the multi-phase power converter, and wherein the control circuit (1) is configured to determine the current signal based on the phase current signals.

11. A method of controlling a power converter (2), the method comprising
- receiving, by a control circuit (1), a voltage signal indicative of an output voltage (Vout) at an output (26) of the power converter (2),
- receiving, by the control circuit (1), a current signal indicative of an output current (Iout) at the output (26) of the power converter (2),
- determining, by the control circuit (1), a fault condition associated with the voltage signal based on the current signal and based on the voltage signal; and
- **characterized by** determining, by the control circuit (1), the fault condition if a value of the current signal exceeds a current fault threshold (Ipeak thresh) and if a value of the peak Delta output voltage (Peak Delta Vout) is below a voltage fault threshold (Delta Vout thresh).

12. The method according to claim 11, wherein the determining comprises determining the fault condition if a value of the current signal exceeds a current fault threshold and if a value of the voltage signal is below a voltage fault threshold.

13. The method according to claim 11 or 12, comprising determining the maximum value of the current signal within a predetermined time interval, and using this maximum value as the value of the current signal for determining the fault condition.

14. A computer program comprising instructions which, when executed by one or more processors of a control circuit (1), cause the control circuit to perform operations of any one of claims 11 to 13.
